# EUROPÄISCHE PATENTANMELDUNG

(11) **EP 3 451 476 A1**
(43) Veröffentlichungstag der Anmeldung: **06.03.2019**
(21) Anmeldenummer: 17188368.9
(22) Anmeldetag: 29.08.2017
(51) Int. Cl.: H02H 3/42, H02H 7/22, H02M 3/156, H02M 3/335, H02M 7/155

(54) **VERFAHREN UND SCHALTUNG ZUR EINHALTUNG VON MAXIMALWERTEN FÜR AUSGANGSPARAMETER EINER STROMVERSORGUNG**

(71) Anmelder: Siemens Aktiengesellschaft, 80333 München (DE)
(72) Erfinder: Paul, Wolfgang, 2344 Maria Enzersdorf (AT); Benesch, Karl, 3340 Waidhofen/Ybbs (AT)
(74) Vertreter: Maier, Daniel Oliver

(57) **Zusammenfassung**

Die Erfindung betrifft ein Verfahren sowie einen Schaltung zur Einhaltung vorgegebener Maximalwerte für Ausgangsparameter zumindest einer Stromversorgung (SV, SV1, ..., SVn), welche zumindest einen potentialgebundenen Schaltwandler, eine Ausgangsspannungsregeleinheit, eine Strombegrenzung und ein Schaltelement (SE) aufweist. Dabei werden laufend aktuelle Werte eines Ausgangsstroms (Ia, Ia1, ..., Ian) der Stromversorgung (SV, SV1, ..., SVn) sowie einer Ausgangsspannung (Ua, Ua1, ..., Uan) der Stromversorgung (SV, SV1, ..., SVn) gemessen. Von einer Auswerteeinheit (AW) werden aus den aktuellen gemessenen Werten des Ausgangsstroms (Ia, Ia1, ..., Ian) und der Ausgangsspannung (Ua, Ua1, ..., Uan) aktuelle Ausgangsleistungswerte für die Stromversorgung (SV, SV1, ..., SVn) ermittelt und dann zumindest die jeweils aktuell gemessenen Werte des Ausgangsstroms (Ia, Ia1, ..., Ian) sowie die jeweils aktuell ermittelten Ausgangsleistungswerte mit vorgegebenen Maximalwerten verglichen. Wird zumindest einer der vorgegebenen Maximalwerte durch einen aktuell gemessenen Wert des Ausgangsstroms (Ia, Ia1, ..., Ian) und/oder durch einen aktuell ermittelten Ausgangsleistungswert überschritten, so wird ein Stromfluss in der Stromversorgung (SV, SV1, ..., SVn) von der Auswerteeinheit (AW) unterbrochen.

## Beschreibung

### Technisches Gebiet

Die vorliegende Erfindung betrifft ein Verfahren zu Einhaltung vorgegebener Maximalwerte für Ausgangsparameter zumindest einer Stromversorgung, insbesondere für einen Ausgangsstrom und eine Ausgangsleistung, insbesondere wenn in der zumindest einen Stromversorgung ein so genannter Einfachfehler auftritt. Die zumindest eine Stromversorgung umfasst dabei zumindest einen potentialgebundenen Schaltwandler, ein Schaltelement, eine Ausgangsspannungsregeleinheit und eine interne Strombegrenzung. Weiterhin betrifft die vorliegende Erfindung auch eine zugehörige Schaltung zur Durchführung des erfindungsgemäßen Verfahrens.

### Stand der Technik

Bei vielen elektrischen Anlagen werden heutzutage häufig Stromversorgungen eingesetzt, welche eine Gleichspannung als Ausgangsspannung zur Versorgung liefern. Solche Stromversorgungen werden oft in Schaltschränken für elektrische Anlagen eingesetzt, um beispielsweise einer Steuerelektronik oder anderen Teilen der elektrischen Anlage eine vordefinierte Versorgungsspannung zur Verfügung zu stellen. Derartige Stromversorgungen liefern als vordefinierte Versorgungsspannung eine vorgegebene Ausgangsspannung (z.B. 24V Gleichspannung als Nennausgangsspannung und 28V Gleichspannung als maximale Ausgangsspannung).

Eine solche Stromversorgung wird üblicherweise aus einem einphasigen oder dreiphasigen Energieversorgungsnetz, insbesondere einem Drehstromnetz, gespeist. Daher ist für eine solche Stromversorgung häufig eine Eingangsstufe (z.B. Gleichrichtereinheit, etc.) vorgesehen, durch welche die Wechselspannung aus dem Energieversorgungsnetz in eine Gleichspannung als Eingangsspannung für die Stromversorgung umgewandelt wird. Von der Stromversorgung wird die meist unstabilisierte Eingangsspannung dann in eine konstante Ausgangsspannung bzw. in die vordefinierte Versorgungsspannung für die elektrische Anlage umgewandelt, wobei eine Konstanz der Ausgangsspannung und/oder eines Ausgangsstroms durch eine Regelung des Energieflusses erreicht wird. Dazu umfasst eine derartige Stromversorgung zumindest einen Schaltwandler und ein periodisch arbeitendes, elektronisches Schaltelement. Es können dabei potentialtrennende Schaltwandler, welche eine galvanische Trennung (z.B. Transformator) aufweisen, oder potentialgebundene (d.h. nicht potentialtrennende) Schaltwandler ohne galvanische Trennung eingesetzt werden. Bei einfachen, in Schaltschränken eingebauten Stromversorgungen werden z.B. aus Gründen einer kostengünstigeren Ausgestaltung der zu versorgenden Anlage mit potentialgetrennter Sicherheitskleinspannung potentialgebundene Schaltwandler verwendet. Zur Einhaltung der vorgegebenen Ausgangsspannung ist weiterhin eine Ausgangsspannungsregeleinheit vorgesehen.

Bei in Schaltschränken installierten Stromversorgungen können Energiebegrenzungen bzw. eine Begrenzung der Ausgangsleistung der Stromversorgung (z.B. Nennausgangsleistung kleiner 100W) vorgesehen sein und z.B. aus Sicherheitsgründen eine Einhaltung von Vorgaben aus entsprechenden Normen und/oder Zertifizierungsrichtlinien gefordert werden. Derartige Vorgaben sind z.B. in der so genannte UL508 Class 2, wobei UL für Unterwriters Laboratories Inc.® steht - einer der weltweit führenden Organisationen für die Prüfung und Zertifizierung im Bereich der Produktsicherheit, oder in der amerikanischen Norm NEC Class 2 (National Electrical Code Class 2) festgelegt. Mindestsicherheitsanforderungen für ein Gerät oder System werden auch von den Normen der International Electrotechnical Commission (IEC) festgelegt.

Zur Einhaltung der Vorgaben aus Normen und Richtlinien, insbesondere nach UL508 Class 2, dürfen von einer Stromversorgung an ihrem Ausgang vorgegebene Maximalwerte für jeweilige Ausgangsparameter, insbesondere für den Ausgangsstrom (z.B. maximal 8A) und eine Ausgangsleistung (z.B. maximal 100W), nicht überschritten werden, um beispielsweise daran anschließende, kostengünstigere Leitungen verlegen zu können. Daher umfasst eine derartige Stromversorgung auch eine interne Strombegrenzung, durch welche verhindert wird, dass der Ausgangsstrom einen vorgegebenen Maximalwert übersteigt bzw. durch welche mit steigendem Ausgangsstrom die Ausgangsspannung derart nachgeregelt wird, dass die maximal zulässige Ausgangsleistung nicht überschritten wird. Zur Einhaltung der Vorgaben (z.B. nach UL508 Class 2) werden diese Werte laufend gemessen und überwacht. Dabei muss allerdings sichergestellt sein, dass die vorgegebenen Maximalwerte der Ausgangsparameter - vor allem für den Ausgangsstrom und die Ausgangsleistung - auch bei Vorliegen eines Einfachfehlers in der Stromversorgung (z.B. Fehler in Ausgangsspannungsregeleinheit, Fehler in der Strombegrenzung, fehlerhaftes Schalten des Schaltwandlers, etc.) durch entsprechende Maßnahmen (z.B. Abschalten der Stromversorgung bei Werteüberschreitung) eingehalten werden.

Um eine Einhaltung der Maximalwerte z.B. entsprechend der Vorgaben der UL508 Class 2 sicherzustellen, können beispielsweise im Ausgangskreis der Stromversorgung zusätzliche, redundante Schaltungskomponenten implementiert werden - z.B. ein redundante Ausführung der Strombegrenzung und der Ausgangsspannungsregeleinheit. Weiterhin sind Schaltungskomponenten z.B. für eine Vorgabe der Maximal- bzw. Grenzwerte der jeweiligen Ausgangsparameter (z.B. Ausgangsstrom, Ausgangsleistung), für eine Erfassung von Ausgangsstrom und -spannung sowie eine Abschalteinrichtung bei der Stromversorgung vorzusehen. Diese Schaltungskomponenten können ebenfalls redundant ausgeführt werden, um bei Vorliegen eines Einfachfehlers (z.B. Kurzschluss oder Unterbrechung in einer der Mess-, Auswerte- oder Abschaltkomponenten) ein Einhalten der vorgegebenen Maximalwerte der Ausgangsparameter bzw. ein sicheres Abschalten bei Überschreiten dieser Maximalwerte zu gewährleisten.

Die Schaltung der Stromversorgung wird durch die zusätzlichen und meist redundant ausgeführten Schaltungskomponenten zur Einhaltung der vorgegebenen Maximalwerte der Ausgangsparameter allerdings relativ komplex und aufwendig. Durch die zusätzlichen Schaltungskomponenten entstehen beispielsweise auch höhere Kosten, eine höhere Fehleranfälligkeit und gegebenenfalls auch mehr Platzbedarf für die Stromversorgung. Weiterhin können beispielsweise manche Fehler - so genannte "schlafende" Fehler - durch die zusätzlichen Schaltungskomponenten nur schlecht erkannt und dadurch gegebenenfalls ein Abschalten der Stromversorgung bei Überschreiten der vorgegebenen Maximalwerte für die Ausgangsparameter verhindert werden.

### Darstellung der Erfindung

Der Erfindung liegt daher die Aufgabe zugrunde, ein Verfahren sowie eine Schaltung anzugeben, durch welche auf einfache und kostengünstige Weise Fehler in einer Stromversorgung mit potentialgebundenen Schaltwandler besser und rascher erkannt und eine Einhaltung vorgegebener Maximal- oder Nennwerte der Ausgangsparameter für die Stromversorgung sicher gewährleistet wird.

Diese Aufgabe wird durch ein Verfahren und eine Schaltung der eingangs genannten Art mit den Merkmalen gemäß den unabhängigen Patentansprüchen gelöst. Vorteilhafte Ausführungsformen der vorliegenden Erfindung sind in den abhängigen Ansprüchen beschrieben.

Erfindungsgemäß erfolgt die Lösung der Aufgabe durch ein Verfahren der eingangs erwähnten Art, bei welchem laufend aktuelle Werte eines Ausgangsstroms und einer Ausgangsspannung der zumindest einen Stromversorgung gemessen werden. Aus den jeweils aktuell gemessenen Werten von Ausgangsstrom und Ausgangsspannung werden dann jeweils aktuelle Ausgangsleistungswerte für die zumindest eine Stromversorgung von einer Auswerteeinheit ermittelt. Die jeweils aktuell gemessenen Werte des Ausgangsstroms sowie die jeweils aktuell ermittelten Ausgangsleistungswerte werden von der Auswerteeinheit mit den entsprechenden, vorgegebenen Maximalwerten für Ausgangsstrom und Ausgangsleistung verglichen. Bei Überschreiten von zumindest einem der vorgegebenen Maximalwerte durch einen aktuell gemessenen Wert des Ausgangsstroms und/oder durch einen aktuell ermittelten Ausgangsleistungswert wird von der Auswerteeinheit ein Stromfluss der zumindest einen Stromversorgung unterbrochen - d.h. die zumindest eine Stromversorgung wird dauerhaft abgeschaltet.

Der Hauptaspekt der gegenständlichen Erfindung besteht darin, dass durch einen Einsatz der Auswerteeinheit, von welcher die aktuell gemessenen Werte von Ausgangsstrom und Ausgangsspannung sowie ein daraus aktuell ermittelter Ausgangsleistungswert überwacht und im Bezug auf die vorgegebenen Maximalwerte ausgewertet werden, eine einfache und kostengünstige Stromversorgung realisiert werden kann, von welcher Sicherheitsanforderungen z.B. der UL508 Class 2 insbesondere auch bei Auftreten von einzelnen Fehlern in der Stromversorgung (z.B. Kurzschluss oder Unterbrechung in einer Komponente der Stromversorgung, etc.) eingehalten werden. D.h. Ausgangsstrom und Ausgangsleistung der Stromversorgung werden mit der Auswerteeinheit laufend auf eine Einhaltung der maximal zulässigen Werte (z.B. maximale Nennausgangsleistung von 100W, maximaler Ausgangsstrom von 8A) überprüft und bei einer Überschreitung der vorgegebenen Maximalwerte kann ein Stromfluss der Stromversorgung dauerhaft und sicher unterbrochen werden. In der Folge kann auch eine Verkabelung deutlich einfacher und billiger unter Einhaltung entsprechender Vorschriften gestaltet werden.

Mit Hilfe des erfindungsgemäßen Verfahrens und dem Einsatz der Auswerteeinheit können weiterhin Fehler - insbesondere "schlafende" Fehler - in der Schaltung der Stromversorgung besser und rascher erkannt werden, da die wesentlichen Messwerte (z.B. Ausgangsstrom, Ausgangsspannung, etc.) laufend und aktuell erfasst und ausgewertet werden. Zusätzlich können mit Hilfe der Auswerteeinheit die Ausgangsparameter - insbesondere Ausgangsstrom und Ausgangsleistung - anwendungs-und/oder kundenspezifisch begrenzt werden. Diese anwendungs-und/oder kundenspezifischen Grenzwerte können beispielsweise bei der Auswerteeinheit sehr einfach eingestellt und von dieser sehr einfach überprüft werden. Beim Einstellen der anwendungs- und/oder kundenspezifischen Grenzwerte ist weiterhin zu beachten, dass diese innerhalb der vorgegebenen Maximalwerte liegen bzw. die Vorgaben von Sicherheitsvorschriften/- normen (z.B. UL508 Class 2) erfüllen.

Weiterhin ist es vorteilhaft, wenn laufend aktuelle Werte eines Eingangsstroms der zumindest einen Stromversorgung sowie aktuelle Werte einer Eingangsspannung der zumindest einen Stromversorgung gemessen werden. Aus den jeweils aktuell, gemessenen Werten von Eingangsstrom und Eingangsspannung der zumindest einen Stromversorgung werden von der Auswerteeinheit jeweils aktuelle Eingangsleistungswerte für die zumindest eine Stromversorgung ermittelt. Es wird dann von der Auswerteeinheit eine Differenz zwischen jeweils aktuell ermittelten Ausgangsleistungswerten und jeweils aktuell ermittelten Eingangsleistungswerten bestimmt und mit einer vorgegebenen, maximal zulässigen Leistungsdifferenz verglichen. Wird diese maximal zulässige Leistungsdifferenz von der ermittelten Differenz aus aktuell ermitteltem Ausgangsleistungswert und Eingangsleistungswert überschritten, so wird der Stromfluss der zumindest einen Stromversorgung von der Auswerteeinheit unterbrochen bzw. die Stromversorgung dauerhaft abgeschaltet. Durch den Vergleich eines aktuell ermittelten Ausgangsleistungswerts mit einem aktuell ermittelten Eingangsleistungswert können auf einfache Weise Einfachfehler bei Schaltungskomponenten der Stromversorgung oder in Messeinheiten festgestellt werden - insbesondere wenn aufgrund des Fehlers die aktuell gemessenen Werte von Ausgangsstrom und Ausgangsspannung bzw. der daraus ermittelte Ausgangsleistungswert verfälscht sind.

Im Idealfall sind die Eingangsleistung und die Ausgangsleistung bei einer Stromversorgung mit potentialgebundenen Schaltwandler bis auf einen zulässigen Toleranzbereich gleich. Durch die Vorgabe der maximal zulässigen Leistungsdifferenz wird dieser zulässige Toleranzbereich berücksichtigt, welcher z.B. durch Erfassungsgenauigkeit, Filter, Leistungsermittlung, etc. beeinflusst wird. Bei Überschreiten der maximal zulässigen Leistungsdifferenz durch die Differenz zwischen den jeweils aktuell ermittelten Eingangs- und Ausgangsleistungswerten kann ein Vorliegen eines Fehlers oder einer Fehlfunktion in der Stromversorgung angenommen werden, welche die Einhaltung der vorgegebenen Maximalwerte verhindert. Durch entsprechende Maßnahmen wie das Unterbrechen des Stromflusses der Stromversorgung durch die Auswerteeinheit wird die Einhaltung der vorgegebenen Maximalwerte sichergestellt.

Bei einer bevorzugten Weiterbildung des erfindungsgemäßen Verfahrens ist vorgesehen, dass von der Auswerteeinheit regelmäßig ein Triggersignal an eine Überwachungseinheit gesendet wird. Von der Überwachungseinheit wird ein laufender Empfang des Triggersignals überwacht und bei Ausbleiben des Triggersignals ein Reset-Signal an die Auswerteeinheit gesendet. Durch das Reset-Signal bzw. das Zurücksetzen der Auswerteeinheit wird auch der Stromfluss der zumindest einen Stromversorgung unterbrochen. Durch den Einsatz der Überwachungseinheit kann sehr einfach die Funktion der Auswerteeinheit überprüft werden. Im Fall einer Fehlfunktion der Auswerteeinheit kann beispielsweise durch ein Zurücksetzen der Auswerteeinheit mittels des Reset-Signals diese behoben werden. Weiterhin wird dafür gesorgt, dass eine Fehlfunktion der Auswerteeinheit selbst nicht zu einer Überschreitung der vorgegebenen Maximalwerte der Ausgangsparameter der Stromversorgung führt.

Weiterhin ist es günstig, wenn von der Auswerteeinheit ein Betrieb des Schaltwandlers der zumindest einen Stromversorgung außerhalb eines spannungsgeregelten Bereichs und eines stromgeregelten Bereichs anhand der aktuell gemessenen Werte von Ausgangsstrom und Ausgangsspannung erkannt wird und dann von der Auswerteeinheit der Stromfluss der zumindest einen Stromversorgung unterbrochen wird. Dazu können beispielsweise von der Auswerteeinheit die aktuell gemessenen Werte von Ausgangstrom und Ausgangsspannung mit Regelsollwerten für diese Parameter verglichen werden. Durch Abweichungen der aktuell gemessenen Werte von den Regelsollwerten kann beispielsweise ein Betrieb des Schaltwandlers außerhalb des spannungsgeregelten wie des stromgeregelten Bereichs erkannt und dadurch eine Fehlfunktion in der Ausgangsspannungsregeleinheit und/oder in der internen Strombegrenzung der Stromversorgung angenommen werden. Mit Hilfe der Auswerteeinheit kann der Stromfluss der Stromversorgung unterbrochen und damit die Einhaltung der vorgegebenen Maximalwerte der Ausgangsparameter sichergestellt werden.

Idealer Weise wird auch eine Versorgungsspannung der Auswerteeinheit gemessen und von der Auswerteeinheit mit einem vorgegebenen zulässigen Wertebereich für die Versorgungsspannung verglichen. Durch eine Überprüfung der Versorgungsspannung kann sehr einfach festgestellt werden, ob von einer korrekten Referenzspannung z.B. für die gemessenen Werte ausgegangen wird. Bei einer Abweichung der gemessenen Versorgungsspannung vom vorgegebenen, zulässigen Wertebereich wird der Stromfluss der zumindest einen Stromversorgung von der Auswerteeinheit unterbrochen, da aufgrund einer falsch angenommenen oder vorgegebenen Referenzspannung Fehler bei der Messung und Auswertung der aktuellen Werte von Eingangsspannung, Eingangsstrom, Ausgangsstrom und Ausgangsspannung vorliegen können.

Zum Unterbrechen des Stromflusses der zumindest einen Stromversorgung kann idealerweise das Schaltelement der zumindest einen Stromversorgung durch die Auswerteeinheit entsprechend angesteuert werden. Von der Auswerteeinheit kann dazu ein entsprechendes Steuersignal an das Schaltelement der Stromversorgung übermittelt werden, durch welches das Schaltelement je nach aktuellem Schaltzustand geöffnet wird oder geöffnet bleibt. Der Schalttakt des Schaltwandlers wird damit beendet. Durch die Nutzung des Schaltelements der Stromversorgung ist eins Einbau eines zusätzlichen Schaltelements (z.B. Leistungsschalter zur Sicherheitsabschaltung, etc.) nicht notwendig.

Alternativ oder zusätzlich kann zum Unterbrechen des Stromflusses ein ansteuerbares Schaltelement eingesetzt werden, welche eingangsseitig bei der zumindest einen Stromversorgung angebracht ist. Dieses zusätzliche, ansteuerbare Schaltelement kann dann von der Auswerteeinheit z.B. mittels eines Steuersignals entsprechend angesteuert werden. D.h. das zusätzliche Schaltelement wird geöffnet, wenn von der Auswerteeinheit das Vorliegen einer Fehlfunktion oder eines Einfachfehlers in der Stromversorgung angenommen wird. Alternativ zu einem zusätzlichen Schaltelement kann auch ein Schaltwandler verwendet werden, welche der zumindest einen Stromversorgung entweder vorgelagert oder nachgelagert wird.

Die angeführte Aufgabe wird weiterhin durch eine Schaltung zur Durchführung des erfindungsgemäßen Verfahrens gelöst. Diese Schaltung umfasst zumindest eine Stromversorgung, welche zumindest einen potentialgebundenen Schaltwandler, ein Schaltelement, eine Ausgangsspannungsregeleinheit sowie eine interne Strombegrenzung aufweist. Weiterhin umfasst die erfindungsgemäße Schaltung Messeinheiten, welche zum laufenden Messen aktueller Werte eines Ausgangsstroms und einer Ausgangsspannung der zumindest einen Stromversorgung eingerichtet sind. Die erfindungsgemäße Schaltung weist auch eine Auswerteeinheit auf, welche dazu eingerichtet ist, aus aktuell gemessenen Werten des Ausgangsstroms und der Ausgangsspannung der zumindest einen Stromversorgung aktuelle Ausgangsleistungswerte zu ermitteln, die jeweils aktuell gemessenen Werte des Ausgangsstroms und die jeweils aktuell ermittelten Ausgangsleistungswerte mit vorgegebenen Maximalwerten zu vergleichen und bei einer Überschreitung von zumindest einem vorgegebenen Maximalwert einen Stromfluss der zumindest einen Stromversorgung zu unterbrechen.

Der Hauptaspekt der erfindungsgemäßen Schaltung besteht vor allem darin, dass durch eine Verwendung der Auswerteeinheit außer Messeinheiten zum laufenden Messen der aktuellen Werte von Ausgangsstrom und Ausgangsspannung keine weiteren zusätzlichen und/oder redundanten Schaltungskomponenten implementiert werden müssen. Die erfindungsgemäße Schaltung ermöglicht die Realisierung einer einfachen, kostengünstigen und platzsparenden Stromversorgung, durch welche auf einfache Weise vorgegebenen Maximalwerte der Ausgangsparameter und damit Sicherheitsanforderungen wie z.B. von der UL508 Class 2 insbesondere auch bei Auftreten von einzelnen Fehlern und Fehlfunktionen in der Stromversorgung (z.B. Kurzschluss oder Unterbrechung in einer Komponente der Stromversorgung, etc.) eingehalten werden. Da Schaltungskomponenten der Stromversorgung nicht redundant ausgeführt werden müssen und/oder zusätzliche Schaltungskomponenten durch den Einsatz der Auswerteeinheit nicht mehr notwendig sind, wird auch die Fehleranfälligkeit durch die reduzierte Anzahl an Schaltungskomponenten der Stromversorgung geringer. Durch dem Einsatz der Auswerteeinheit können weiterhin Fehler - insbesondere "schlafende" Fehler - in der Schaltung der Stromversorgung besser und rascher erkannt werden, da die wesentlichen Messwerte (z.B. Ausgangsstrom, Ausgangsspannung, etc.) laufend und aktuell erfasst und ausgewertet werden.

Bei Stromversorgungen, welche aufgrund funktionaler Anforderungen bereits einen Mikrocontroller z.B. als Steuereinheit aufweisen, besteht der Vorteil, dass für eine Implementierung der Auswerteeinheit der bereits vorhandene Mikrocontroller genutzt werden kann. Weiterhin können von einer Auswerteeinheit mehrere Stromversorgungen auf die Einhaltung vorgegebener Maximalwerte der jeweiligen Ausgangsparameter parallel überwacht und bei Erkennen einer Fehlerfunktion in einer der Stromversorgungen der Stromfluss der entsprechenden Stromversorgung von der Auswerteeinheit unterbrochen werden. Dadurch kann die erfindungsgemäße Schaltung noch platzsparender und kostengünstiger gestaltet werden.

Bei einer vorteilhaften Ausgestaltung der erfindungsgemäßen Schaltung sind weiterhin Messeinheiten zum Messen aktueller Werte einer Eingangsspannung und eines Eingangsstroms der zumindest einen Stromversorgung vorgesehen. Die Auswerteeinheit ist dann dazu eingerichtet, aus den aktuell gemessenen Werten der Eingangsspannung und des Eingangsstroms aktuelle Eingangsleistungswerte zu ermitteln, eine Differenz zwischen jeweils aktuell ermittelten Ausgangsleistungswerten und jeweils aktuell ermittelten Eingangsleistungswerten zu bestimmen, mit einer maximal zulässigen Leistungsdifferenz zu vergleichen und bei Überschreitung der maximal zulässigen Leistungsdifferenz den Stromfluss zu unterbrechen. Durch ein Messen von Eingangsspannung und -strom bzw. ein Ermitteln eines aktuellen Eingangsleistungswerts, welche mit dem aktuell ermittelten Ausgangsleistungswert verglichen wird, können auf einfache Weise Einfachfehler und Fehlfunktionen wie z.B. Kurzschluss, Unterbrechungen, etc. in Schaltungskomponenten der Stromversorgung erkannt und ein Überschreiten der vorgegebenen Maximalwerte der Ausgangsparameter verhindert werden.

Es ist auch von Vorteil, wenn eine Überwachungseinheit zum Empfangen eines Triggersignals der Auswerteeinheit und zum Senden eines Reset-Sginals bei Ausbleiben des Triggersignal vorgesehen ist. Durch das Reset-Signal ist die Auswerteeinheit zurücksetzbar und der Stromfluss der zumindest einen Stromversorgung wird dadurch unterbrochen. Durch die Überwachungseinheit wird auf einfache und effiziente Weise sichergestellt, dass Fehlfunktionen der Auswerteeinheit selbst zu einer Nicht-Einhaltung der vorgegebenen Maximalwerte der Ausgangsparameter der Stromversorgung führen.

Zum Unterbrechen des Stromflusses der zumindest einen Stromversorgung kann idealerweise das Schaltelement der zumindest einen Stromversorgung durch die Auswerteeinheit entsprechend ansteuerbar sein. Die Verwendung des bereits in der Stromversorgung bzw. vom zugehörigen Schaltwandler für den Schalttakt genutzten Schaltelements hält die erfindungsgemäße Schaltung einfach. Allerdings ist die Verwendung des Schaltelements der Stromversorgung zum Unterbrechen des Stromflusses durch die Auswerteeinheit auf Schaltungstopologien beschränkt, bei welchen aufgrund eines Bauteilfehler und/oder einer Fehlfunktion des Schaltelements keinen leitendende Verbindung zwischen einer Eingangsseite und einer Ausgangsseite der Stromversorgung hergestellt werden kann.

Daher kann es günstig sein, wenn als potentialgebundener Schaltwandler ein Schaltwandler nach dem so genannten SEPIC-Konzept oder ein potentialgebundener Sperrwandler vorgesehen ist. Bei diesen Schaltwandler-Topologien wird durch eine entsprechende Ansteuerung des zugehörigen Schaltelements der Stromfluss sicher beendet. Idealerweise weist der Schaltwandler nach dem so genannten SEPIC-Konzept dabei zumindest zwei serielle Längs- oder Kopplungskondensatoren auf. Dies hat den Vorteil, dass selbst bei einem Kurzschluss eines der Längs-oder Kopplungskondensatoren kein Strom vom Eingang zum Ausgang und zurück fließen kann.

Alternativ oder zusätzlich, zur Nutzung des stromversorgungsinternen Schaltelements zum Unterbrechen des Stromflusses kann die erfindungsgemäße Schaltung ein zusätzliches Schaltelement aufweisen, welches auf einer Eingangsseite der zumindest einen Stromversorgung angebracht ist. Durch dieses zusätzliche Schaltelement ist bei entsprechender Ansteuerung durch die Auswerteeinheit der Stromfluss der zumindest einen Stromversorgung unterbrechbar. Alternativ zu einem zusätzlichen Schaltelement kann zum Unterbrechen des Stromflusses der zumindest einen Stromversorgung auch ein Schaltwandler vorgesehen sein, welcher der zumindest einen Stromversorgung vorgelagert oder nachgelagert ist.

Alternativ zu einem SEPIC-Wandler oder einem potentialgebundenen Sperrwandler kann als potentialgebundener Schaltwandler auch ein Tiefsetzsteller oder ein Hochsetzsteller vorgesehen sein. Bei diesen Schaltwandlern ist allerdings ein zusätzliches Schaltelement eingangsseitig bei der Stromversorgung oder ein vor- oder nachgelagerter Schaltwandler zum Unterbrechen des Stromflusses der Stromversorgung vorzusehen.

### Kurzbeschreibung der Zeichnung

Die Erfindung wird nachfolgend in beispielhafter Weise anhand der beigefügten Figuren erläutert. Dabei zeigen:
- Figur 1: schematisch eine beispielshafte Ausführungsform der erfindungsgemäßen Schaltung zur Durchführung des Verfahrens zur Einhaltung vorgegebener Maximalwerte für Ausgangsparameter mit einer Stromversorgung
- Figur 2: schematisch eine weitere, beispielhafte Ausführungs-form der erfindungsgemäßen Schaltung, bei welcher zusätzlich auch Eingangsparameter der Stromversorgung gemessen werden
- Figur 3: schematisch eine beispielshafte Ausführungsform der erfindungsgemäßen Schaltung zur Durchführung des Verfahrens zur Einhaltung vorgegebener Maximalwerte für Ausgangsparameter mit mehreren Stromversorgungen
- Figur 4: schematisch eine beispielshafte Ausführungsform der erfindungsgemäßen Schaltung zur Durchführung des Verfahrens zur Einhaltung vorgegebener Maximalwerte für Ausgangsparameter einer Stromversorgung mit einem so genannten SEPIC-Wandler

### Ausführung der Erfindung

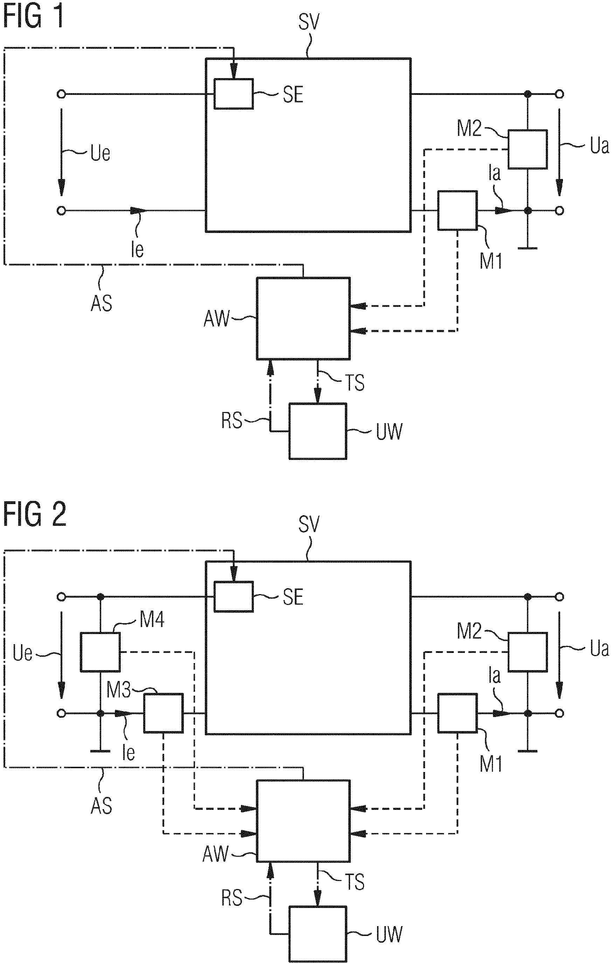

Figur 1 zeigt in schematischer Weise eine beispielhafte Ausführungsform der erfindungsgemäßen Schaltung, mit welcher das erfindungsgemäße Verfahren zur Einhaltung vorgegebener Maximalwerte von Ausgangsparameter, vor allem eines Ausgangsstroms Ia und/oder einer Ausgangsleistung, einer Stromversorgung SV durchgeführt werden kann. Die Maximalwerte der Ausgangsparameter bzw. für den Ausgangsstrom Ia und die Ausgangsleistung der Stromversorgung SV können beispielsweise durch Sicherheitsvorgaben und/oder Richtlinien wie z.B. der UL508 Class2 oder NEC Class2 vorgegeben werden.

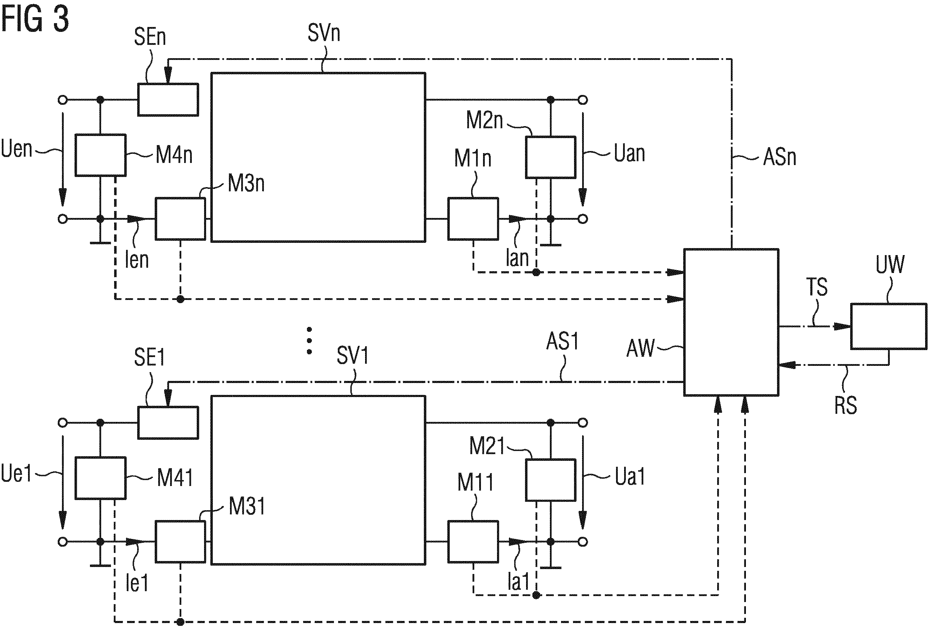

Die erfindungsgemäße Schaltung umfasst dabei die Stromversorgung SV, welche zumindest einen potentialgebundenen Schaltwandler, ein Schaltelement SE, eine Ausgangsspannungsregeleinheit und eine interne Strombegrenzung aufweist. In der Figur 1 sowie den folgenden Figuren 2 und 3 wird auf eine detaillierte Darstellung der Schaltungskomponenten bzw. Baueinheiten der Stromversorgung SV zu besseren Übersichtlichkeit verzichtet.

Die Stromversorgung SV wird von einer Eingangsspannung Ue bzw. einem Eingangsstrom Ie gespeist und liefert eine vorgegebene Ausgangsspannung Ua (z.B. 24V Gleichspannung) zur Versorgung einer Last bzw. eines Verbrauchers. Ausgangsseitig fließt ein Ausgangsstrom Ia, welcher einen vorgegebenen Maximalwert (z.B. 8 Ampere) nicht überschreiten darf. Weiterhin ist für die Stromversorgung SV, welche z.B. in einem Schaltschrank installiert sein kann, ein Maximalwert für die Ausgangsleistung von z.B. 100 Watt vorgegeben, welcher ebenfalls nicht überschritten werden darf.

Die erfindungsgemäße Schaltung umfasst neben der Stromversorgung SV Messeinheiten M1, M2 zum Messen des Ausgangsstroms Ia und der Ausgangsspannung Ua der Stromversorgung SV. Dabei wird von einer ersten Messeinheit M1 laufend ein aktueller Wert des Ausgangsstroms Ia gemessen. Die erste Messeinheit M1 kann beispielsweise als Shunt ausgeführt sein. Ein Shunt ist üblicherweise ein niederohmiger, elektrischer Widerstand, mit welchem anhand eines Spannungsabfalls, welcher proportional dem zu bestimmenden Strom ist, der Strom ermittelt wird, welcher durch den Shunt fließt. Alternativ kann als erste Messeinheit M1 zum Bestimmen des Ausgangsstroms Ia z.B. auch ein Stromwandler oder eine Einrichtung zur Strommessung mittels Hallsensor verwendet werden. Von einer zweiten Messeinheit M2 wird laufend ein aktueller Wert der Ausgangsspannung Ua der Stromversorgung SV ermittelt. Für die Messung der Ausgangsspannung Ua können beispielsweise Operationsverstärker, Differenzverstärker oder Analog-Digital-Wandler eingesetzt werden.

Weiterhin weist die erfindungsgemäße Schaltung eine Auswerteeinheit AW auf, welche beispielsweise als Mikrocontroller ausgeführt oder auf einem Mikrocontroller, welcher bereits aufgrund funktionaler Anforderungen der Stromversorgung SV vorhanden ist, eingerichtet sein kann. Die von der ersten Messeinheit M1 aktuell gemessenen Werte des Ausgangsstroms Ia und die von der zweiten Messeinheit M2 gemessenen Werte der Ausgangsspannung Ua werden an die Auswerteeinheit AW übertragen. Von der Auswerteeinheit AW wird aus den jeweils aktuellen Werten des Ausgangsstroms Ia und der Ausgangsspannung Ua ein aktueller Ausgangsleistungswert ermittelt. Der jeweilige, aktuell gemessene Wert des Ausgangsstroms Ia wird von der Auswerteeinheit AW mit dem entsprechenden, vorgegebenen Maximalwert für den Ausgangsstrom Ia (z.B. 8 Ampere) verglichen. Weiterhin wird von der Auswerteeinheit AW der jeweilige, aktuell ermittelte Ausgangsleistungswert mit dem vorgegebenen Maximalwert für die Ausgangsleistung (z.B. 100 Watt) verglichen. Wird einer der beiden Maximalwerte oder beide Maximalwerte überschritten - d.h. es wird entweder ein maximal vorgegebener Ausgangsstrom oder eine maximal vorgegebenen Ausgangsleistung oder beide überschritten, dann wird von der Auswerteeinheit AW ein Stromfluss der Stromversorgung SV unterbrochen, da ein Fehler in einer der Schaltungskomponenten der Stromversorgung SV bzw. einen fehlerhafte Funktion der Stromversorgung SV angenommen wird.

Für eine Unterbrechung des Stromflusses der Stromversorgung SV kann von der Auswerteeinheit z.B. mittels eines Steuersignals AS das Schaltelement SE der Stromversorgung SV entsprechend angesteuert werden - d.h., dass z.B. ein Schalttakt des Schaltwandlers der Stromversorgung SV gestoppt wird oder das Schaltelement SE - je aktuellem Schaltzustand - geöffnet wird oder offen bleibt. Das Schaltelement SE der Stromversorgung kann zum Unterbrechen des Stromflusses durch die Auswerteeinheit AW genutzt werden, wenn als potentialgebundener Schaltwandler der Stromversorgung SV beispielsweise ein SEPIC-Wandler oder ein potentialgebundener Sperr- oder Flybackwandler eingesetzt wird. Bei derartigen Wandlertypen ist sichergestellt, dass bei einem Bauteilfehler und/oder einer Fehlfunktion des Schaltelements SE keine leitendende Verbindung zwischen einer Eingangsseite und einer Ausgangsseite der Stromversorgung SV herstellbar ist.

Alternativ oder zusätzlich, kann - wie beispielhaft in Figur 3 dargestellt - ein zusätzliches Schaltelement SE1, ..., SEn auf einer Eingangsseite der Stromversorgung SV vorgesehen sein, welches über ein Steuersignal AS der Auswerteeinheit AW derart angesteuert wird, welches bei Überschreiten eines der Maximalwerte durch einen aktuell gemessenen Wert des Ausgangsstrom Ia oder einen der aktuell ermittelten Ausgangsleistungswerte eine Unterbrechung des Stromflusses der Stromversorgung SV sicherstellt. Alternativ kann der Stromversorgung SV auch ein Schaltwandler vor- oder nachgelagert sein, um den Stromfluss zu unterbrechen. Ein zusätzliches Schaltelement S1, ..., Sn oder ein vor- oder nachgelagerter Schaltwandler wird beispielsweise bei Ausführungsformen der erfindungsmäßigen Schaltung verwendet, wenn als potentialgebundener Schaltwandler der Stromversorgung SV z.B. ein Tiefsetzsteller oder ein Hochsetzsteller vorgesehen ist.

Weiterhin weist die erfindungsgemäße Schaltung eine Überwachungseinheit UW auf, von welcher eine fehlerfreie Funktionsweise der Auswerteeinheit AW überwacht bzw. eine fehlerhafte Funktionsweise der Auswerteeinheit AW erkannt werden kann. Dazu wird von der Auswerteeinheit AW in regelmäßigen Zeitabständen ein Triggersignal TS an die Überwachungseinheit UW ausgesendet. Wird von der Überwachungseinheit UW kein Triggersignal TS der Auswerteeinheit AW empfangen, dann wird von der Überwachungseinheit ein Reset-Signal RS an die Auswerteeinheit AW gesendet. Mittels des Reset-Signals kann die Auswerteeinheit AW zurückgesetzt werden, um z.B. eine mögliche Fehlfunktion zu beheben. Durch das Zurücksetzen der Auswerteeinheit AW wird der Stromfluss der Stromversorgung SV ebenfalls unterbrochen.

Figur 2 zeigt ebenfalls die erfindungsgemäße Schaltung, mit welcher das erfindungsgemäße Verfahren zur Einhaltung vorgegebener Maximalwerte von Ausgangsparameter, vor allem eines Ausgangsstroms Ia und/oder einer Ausgangsleistung, einer Stromversorgung SV durchgeführt werden kann. Dabei weist die erfindungsgemäße Schaltung zusätzlich Messeinheiten M3, M4 auf, welche für ein laufendes Messen aktueller Werte des Eingangsstroms Ie und der Eingangsspannung Ue eingerichtet sind. Dabei werden von einer dritten Messeinheit M3 laufend aktuelle Werte des Eingangsstroms Ie gemessen, welche z.B. als Shunt, Stromwandler oder als Einrichtung zur Strommessung mittels Hallsensor ausgeführt sein kann. Von einer vierten Messeinheit M4 wird laufend ein aktueller Wert der Eingangsspannung Ue der Stromversorgung SV ermittelt. Für die Messung der Eingangsspannung Ue können z.B. ebenfalls Operationsverstärker, Differenzverstärker oder Analog-Digital-Wandler eingesetzt werden.

Die aktuell gemessenen Werte von Eingangsstrom Ie und Eingangsspannung Ue werden ebenfalls an die Auswerteeinheit AW übertragen, von welcher daraus jeweils aktuelle Eingangsleistungswerte ermittelt werden. Von der Auswerteeinheit AW wird dann eine Differenz zwischen den aktuell ermittelten Ausgangsleistungswerten und Eingangsleistungswerten bestimmt und mit einer vorgegebenen, maximal zulässigen Leistungsdifferenz verglichen. Dadurch können auch Fehler in der Stromversorgung SV als auch in den Messeinheiten M1, M2 für Ausgangsstrom Ia und Ausgangsspannung Ua erkannt werden. Wird die vorgegebene, maximal zulässige Leistungsdifferenz von der ermittelten Differenz aus aktuell ermitteltem Ausgangs- und Eingangsleistungswert überschritten, dann wird eine Fehlfunktion in der Stromversorgung SV und/oder den Messeinheiten M1, M2 angenommen. Der Stromfluss der Stromversorgung SV wird daraufhin von der Auswerteeinheit AW z.B. mittels eines Steuersignals AS an das Schaltelement SE der Stromversorgung SV oder an ein zusätzliches Schaltelement bzw. einen zusätzlichen Schaltwandler unterbrochen, um eine Einhaltung der Maximalwerte der Ausgangsparameter der Stromversorgung SV sicherzustellen.

Desweiteren können mit Hilfe der Auswerteeinheit AW die aktuell gemessenen Werte des Ausgangsstroms Ia und der Ausgangsspannung Ua mit entsprechenden Regelsollwerten für Ausgangsstrom Ia und Ausgangsspannung Ua verglichen werden. Wird dabei erkannt, dass die Stromversorgung SV bzw. der Schaltwandler der Stromversorgung SV weder im spannungsgeregelten noch im stromgeregelten Bereich betrieben wird, kann von der Auswerteeinheit AW wieder ein entsprechendes Steuersignal an das Schaltelement SE der Stromversorgung bzw. an ein zusätzliches Schaltelement oder einen entsprechenden vor- oder nachgelagerten Schaltwandler gesendet werden, um den Stromfluss der Stromversorgung SV zu unterbrechen.

Um beispielsweise Fehler durch eine falsche Referenzspannung zu erkennen, kann zusätzlich eine Versorgungsspannung der Auswerteeinheit AW gemessen werden. Von der Auswerteeinheit AW wird die gemessene Versorgungsspannung mit einem vorgegebenen zulässigen Wertebereich für die Versorgungsspannung verglichen und der Stromfluss der Stromversorgung SV unterbrochen, wenn die gemessene Versorgungsspannung vom vorgegebenen zulässigen Wertebereich abweicht bzw. außerhalb dieses Wertebereichs liegt.

Weiterhin können mit der Auswerteeinheit AW auch anwendungs-und/oder kundenspezifische Grenzwerte für die Ausgangsparameter wie Ausgangsstrom Ia, Ausgangsspannung Ua und/oder Ausgangsleistung eingestellt und überwacht werden.

Wie in Figur 3 schematisch und beispielhaft dargestellt, kann die erfindungsgemäße Schaltung auch mehr als eine Stromversorgung SV1, ..., SVn (z.B. bis zu 8 Stromversorgungen SV1, ..., SVn) aufweisen, welche von der Auswerteeinheit AW parallel auf eine Einhaltung der vorgegebenen Maximalwerte der Ausgangsparameter - insbesondere Ausgangsstrom Ia1, ..., Ian und Ausgangsleistung - überwacht werden.

Bei jeder der Stromversorgungen SV1, ..., SVn sind zumindest Messeinheiten M11, ..., M1n zum Messen des jeweiligen Ausgangsstroms Ia1, ..., Ian und Messeinheiten M21, ..., M2n zum Messen der jeweiligen Ausgangsspannung Ua1, ..., Uan angebracht. Die aktuellen Messwerte der Messeinheiten M11, ..., M1n, M21, ..., M2n werden wieder an die Auswerteeinheit AW übertragen und je Stromversorgung SV1, ..., SVn daraus aktuelle Ausgangsleistungswerte ermittelt. Von der Auswerteeinheit AW wird dann je Stromversorgung SV1, ..., SVn eine Einhaltung der vorgegebenen Maximalwerte für Ausgangsstrom Ia1, ..., Ian und Ausgangsleistung überprüft. Wird von einer der Stromversorgung SV1, ..., SVn oder mehreren ein Maximalwert oder beide Maximalwerte nicht eingehalten, so wird bei dieser oder diesen Stromversorgungen SV1, ..., SVn der Stromfluss von der Auswerteeinheit AW unterbrochen. Dazu kann von der Auswerteeinheit AW z.B. mittels eines Steuersignals AS1, ..., ASn - wie bereits ausgeführt - ein zusätzliches Schaltelement SE1, ..., SEn der jeweiligen, betroffenen Stromversorgung SV1, ..., SVn entsprechend angesteuert werden. Alternativ kann beim Einsatz entsprechender Schaltwandler (z.B. SEPIC-Wandler, Sperrwandler) in den Stromversorgungen SV1, ..., SVn auch das interne Schaltelement der jeweiligen Stromversorgungen SV1, ..., SVn zum Unterbrechen des Stromflusses genutzt werden.

Weiterhin können die Stromversorgungen SV1, ..., SVn auch Messeinheiten M31, ..., M3n zum Messen des jeweiligen Eingangsstroms Ie1, ..., Ien und Messeinheiten M41, ..., M4n zum Messen der jeweiligen Eingangsspannung Ue1, ..., Uen aufweisen. Aus den für die jeweilige Stromversorgung SV1, ..., SVn aktuell gemessenen Werten von Eingangsstrom Ie1, ..., Ien und Eingangsspannung Ue1, ..., Uen können von der Auswerteeinheit AW stromversorgungsspezifisch aktuelle Eingangsleistungswerte ermittelt und für jede Stromversorgung SV1, ..., SVn ein Differenz aus aktuell ermittelten Ausgangsleistungs- und Eingangsleistungswert bestimmt werden. Die jeweilige Differenz kann dann von der Auswerteeinheit stromversorgungsspezifisch mit der jeweiligen maximal zulässigen Leistungsdifferenz verglichen werden. Bei Feststellen einer Überschreitung bei einer oder mehreren Stromversorgungen SV1, ..., SVn kann von der Auswerteeinheit AW bei der oder den betroffenen Stromversorgungen SV1, ..., SVn ein Stromfluss unterbrochen werden.

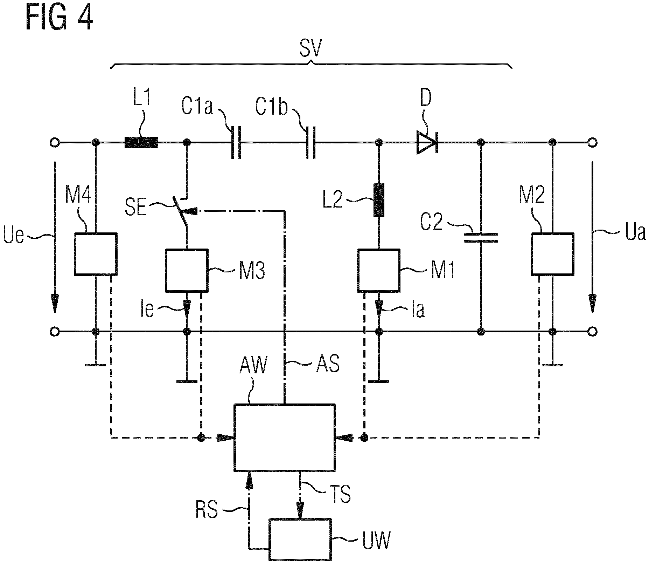

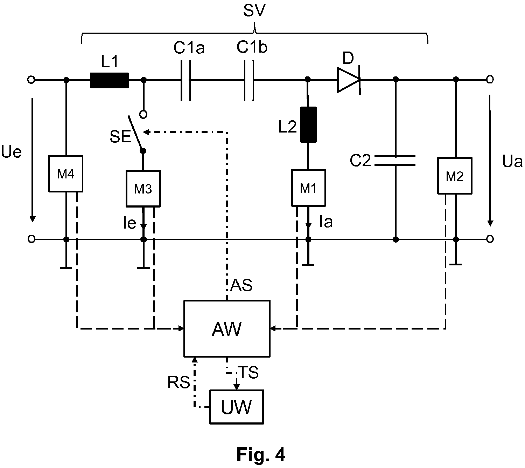

Figur 4 zeigt schematisch eine beispielhafte Ausführungsform der erfindungsgemäßen Schaltung, bei welcher die Stromversorgung SV als potentialgebundenen Schaltwandler einen Schaltwandler nach dem SEPIC-Konzept bzw. einen so genannten SEPIC-Wandler umfasst. Ein SEPIC-Wandler, wobei SEPIC für single ended primary inductance converter steht, ist in der Elektronik eine Form eines Gleichspannungswandlers, bei welchem eine positive Eingangsspannung Ue in eine positive Ausgangsspannung Ua umgesetzt wird. Ein SEPIC-Wandler weist - wie in Figur 4 dargestellt - als wesentliche Elemente ein Schaltelement SE sowie als Energiespeicher zwei Induktivitäten L1, L2 und einen Kondensator C2 auf. Weiterhin sind zumindest ein Längs- oder Kopplungskondensator C1a, C1b sowie eine Diode D vorgesehen. Bei der in Figur 4 dargestellten Ausführungsform des SEPIC-Wandler werden z.B. zwei serielle Längs- oder Kopplungskondensatoren C1a, C1b verwendet, um eine Fehlfunktion durch einen Kurzschluss eines der beiden Kondensatoren C1a, C1b zu verhindern.

Zu Überwachen einer Einhaltung der vorgegebenen Maximalwerte der Ausgangsparameter, vor allem Ausgangsstrom Ia und Ausgangsleistung, bzw. zum Erkennen von Einfachfehler (z.B. Kurzschluss, Unterbrechung) und/oder Fehlfunktionen der Stromversorgung SV sind wieder Messeinheiten M1, M2, M3, M4 vorgesehen, von welchen aktuelle Werte von Ausgangsstrom Ia, Ausgangsspannung Ua, Eingangsstrom Ie und Eingangsspannung Ue gemessen werden. Die Messeinheiten M1, M3 zum Messen von Ausgangsstrom Ia und Eingangsstrom Ie können dabei beispielsweise als Shunts ausgestaltet sein, wobei die erste Messeinheit M1 z.B. seriell zu einer zweiten Induktivität L2 und die dritte Messeinheit M3 z.B. seriell zum Schaltelement SE angeordnet sein kann.

Für die Auswertung der aktuellen Messwerte von Ausgangsstrom Ia, Ausgangsspannung Ua, Eingangsstrom Ie und Eingangsspannung Ue ist die Auswerteeinheit AW vorgesehen, von welcher aus den aktuellen Messewerten aktuelle Ausgangs- und Eingangsleistungswerte ermittelt werden. Von der Ausgangseinheit AW werden wieder die aktuell gemessenen Werte des Ausgangsstroms Ia und die aktuell ermittelten Ausgangsleistungswerte mit den entsprechenden, vorgegebenen Maximalwerten verglichen. Weiterhin wird eine Differenz aus den aktuell ermittelten Ausgangs- und Eingangsleistungswerten ermittelt und mit einer vorgegebenen, maximal zulässigen Leistungsdifferenz verglichen. Wird einer der vorgegebenen Maximalwerte (d.h. maximal zulässiger Ausgangsstrom, maximal zulässige Ausgangsleistung und/oder maximal zulässige Leistungsdifferenz) überschritten, so wird von der Auswerteeinheit AW das Schaltelement SE des SEPIC-Wandlers z.B. mittels eines Steuersignals AS entsprechend angesteuert und der Stromfluss der Stromversorgung SV unterbrochen.

Weiterhin kann die Schaltung beispielsweise wieder eine Überwachungseinheit UW aufweisen. Von der Überwachungseinheit wird eine ordnungsgemäße und fehlerfreie Funktion der Auswerteeinheit AW mittels eines Triggersignals TS der Auswerteeinheit AW überwacht. Bei Ausbleiben des Triggersignals TS kann die Auswerteeinheit AW von der Überwachungseinheit UW mittels eines Reset-Signals RS zurückgesetzt werden und dadurch durch entsprechende Ansteuerung des Schaltelements SE der Stromfluss im Schaltwandler unterbrochen werden.

## Patentansprüche

1. Verfahren zur Einhaltung vorgegebener Maximalwerte für Ausgangsparameter zumindest einer Stromversorgung (SV, SV1, ..., SVn), insbesondere eines Ausgangsstrom (Ia, Ia1,..., Ian) und/oder einer Ausgangsleistung, wobei die zumindest eine Stromversorgung zumindest einen potentialgebundenen Schaltwandler, ein Schaltelement (SE), eine Ausgangsspannungsregeleinheit sowie eine interne Strombegrenzung aufweist, ***dadurch gekennzeichnet, dass*** laufend aktuelle Werte des Ausgangsstroms (Ia, Ia1,..., Ian) der zumindest einen Stromversorgung (SV, SV1, ..., SVn) sowie aktuelle Werte der Ausgangsspannung (Ua, Ua1,..., Uan) der zumindest einen Stromversorgung (SV, SV1, ..., SVn) gemessen werden, dass von einer Auswerteeinheit (AW) aus den aktuell gemessenen Werten von Ausgangsstrom (Ia, Ia1,..., Ian) und Ausgangsspannung (Ua, Ua1,..., Uan) aktuelle Ausgangsleistungswerte für die zumindest eine Stromversorgung (SV, SV1, ..., SVn) ermittelt werden, dass von der Auswerteeinheit (AW) die jeweils aktuell gemessenen Werte des Ausgangsstroms (Ia, Ia1,..., Ian) sowie die jeweils aktuell ermittelten Ausgangsleistungswerte mit den entsprechenden, vorgegebenen Maximalwerten verglichen werden, und dass bei Überschreiten von zumindest einem der vorgegebenen Maximalwerte durch einen aktuell gemessenen Wert des Ausgangsstroms (Ia, Ia1,..., Ian) und/oder durch einen aktuell ermittelten Ausgangsleistungswert ein Stromfluss der zumindest einen Stromversorgung (SV, SV1, ..., SVn) von der Auswerteeinheit (AW) unterbrochen wird.

2. Verfahren nach Anspruch 1, ***dadurch gekennzeichnet, dass*** laufend aktuelle Werte eines Eingangsstroms (Ie, Ie1,..., Ien) der zumindest einen Stromversorgung (SV, SV1, ..., SVn) sowie aktuelle Werte einer Eingangsspannung (Ue, Ue1,..., Uen) der zumindest einen Stromversorgung (SV, SV1, ..., SVn) gemessen werden, dass von der Auswerteeinheit (AW) aus den jeweils aktuell gemessenen Werten von Eingangsstrom (Ie, Ie1,..., Ien) und Eingangsspannung (Ue, Ue1,..., Uen) jeweils aktuelle Eingangsleistungswerte für die zumindest eine Stromversorgung (SV, SV1, ..., SVn) ermittelt werden, dass von der Auswerteeinheit (AW) eine Differenz zwischen jeweils aktuell ermittelten Ausgangsleistungswerten und jeweils aktuell ermittelten Eingangsleistungswerten bestimmt wird und mit einer vorgegebenen, maximal zulässigen Leistungsdifferenz verglichen wird, und dass bei Überschreiten der maximal zulässigen Leistungsdifferenz der Stromfluss der zumindest einen Stromversorgung (SV, SV1, ..., SVn) von der Auswerteeinheit (AW) unterbrochen wird.

3. Verfahren nach einem der Ansprüche 1 bis 2, ***dadurch gekennzeichnet, dass*** von der Auswerteeinheit (AW) regelmäßig ein Triggersignal (TS) an eine Überwachungseinheit (UW) gesendet wird, und dass bei Ausbleiben des Triggersignals (TS) von der Überwachungseinheit (UW) ein Reset-Signal (RS) an die Auswerteeinheit (AW) gesendet und der Stromfluss der zumindest einen Stromversorgung (SV, SV1, ..., SVn) unterbrochen wird.

4. Verfahren nach einem der Ansprüche 1 bis 3, ***dadurch gekennzeichnet, dass*** von der Auswerteeinheit (AW) ein Betrieb des Schaltwandlers der zumindest einen Stromversorgung (SV, SV1, ..., SVn) außerhalb eines spannungsgeregelten Bereichs und eines stromgeregelten Bereichs anhand der aktuell gemessenen Werte von Ausgangsstrom (Ia, Ia1,..., Ian) und Ausgangsspannung (Ua, Ua1,..., Uan) erkannt wird, und dass von der Auswerteeinheit (AW) der Stromfluss der zumindest einen Stromversorgung (SV, SV1, ..., SVn) unterbrochen wird.

5. Verfahren nach einem der Ansprüche 1 bis 4, ***dadurch gekennzeichnet, dass*** eine Versorgungsspannung der Auswerteeinheit (AW) gemessen und von der Auswerteeinheit (AW) mit einem vorgegebenen zulässigen Wertebereich für die Versorgungsspannung verglichen wird, und dass bei einer Abweichung der gemessenen Versorgungsspannung vom vorgegebenen, zulässigen Wertebereich der Stromfluss der zumindest einen Stromversorgung (SV, SV1, ..., SVn) von der Auswerteeinheit (AW) unterbrochen wird.

6. Verfahren nach einem der Ansprüche 1 bis 5, ***dadurch gekennzeichnet, dass*** zum Unterbrechen des Stromflusses der zumindest einen Stromversorgung (SV) das Schaltelement (SE) der zumindest einen Stromversorgung (SV) von der Auswerteeinheit (AW) entsprechend angesteuert wird.

7. Verfahren nach einem der Ansprüche 1 bis 5, ***dadurch gekennzeichnet, dass*** zum Unterbrechen des Stromflusses ein zusätzlich auf einer Eingangsseite der zumindest einen Stromversorgung (SV1, ..., SVn) angebrachtes, ansteuerbares Schaltelement (SE1, ..., SEn) oder eine der zumindest einen Stromversorgung (SV1, ..., SVn) vorgelagerte oder nachgelagerter Schaltwandler verwendet wird.

8. Schaltung zur Einhaltung vorgegebener Maximalwerte für Ausgangsparameter von zumindest einer Stromversorgung (SV, SV1, ..., SVn), umfassend zumindest eine Stromversorgung (SV, SV1, ..., SVn) mit zumindest einem potentialgebundenen Schaltwandler, einem Schaltelement (SE), einer Ausgangsspannungsregeleinheit sowie einer internen Strombegrenzung, wobei die Anordnung zur Durchführung des Verfahrens nach einem der Ansprüche 1 bis 7 eingerichtet ist, ***dadurch gekennzeichnet, dass*** vorgesehen sind:
- Messeinheiten (M1, M2, M11,..., M1n, M21, ..., M2n) zu Messen aktueller Werte eines Ausgangsstroms (Ia, Ia1,..., Ian) und einer Ausgangsspannung (Ua, Ua1,..., Uan) der zumindest einen Stromversorgung (SV); und
- eine Auswerteeinheit (AW), welche dazu eingerichtet ist, aus aktuell gemessenen Werten des Ausgangsstroms (Ia, Ia1,..., Ian) und der Ausgangsspannung (Ua, Ua1,..., Uan) der zumindest einen Stromversorgung (SV, SV1, ..., SVn) aktuelle Ausgangsleistungswerte zu ermitteln, die jeweils aktuell gemessenen Werte des Ausgangsstroms (Ia, Ia1,..., Ian) und die jeweils aktuell ermittelten Ausgangsleistungswerte mit vorgegebenen Maximalwerten zu vergleichen und bei einer Überschreitung von zumindest einem vorgegebenen Maximalwert einen Stromfluss der zumindest einen Stromversorgung (SV, SV1, ..., SVn) zu unterbrechen.

9. Schaltung nach Anspruch 8, ***dadurch gekennzeichnet, dass*** weiterhin Messeinheiten (M3, M4, M31, ..., M3n, M41, ..., M4n) zum Messen aktueller Werte eines Eingangsstroms (Ie, Ie1,..., Ien) und einer Eingangsspannung (Ue, Ue1,..., Uen) der zumindest einen Stromversorgung (SV, SV1, ..., SVn) vorgesehen sind, und dass die Auswerteeinheit (AW) weiterhin dazu eingerichtet ist, aus den aktuell gemessenen Werten der Eingangsspannung (Ue, Ue1,..., Uen) und des Eingangsstroms (Ie, Ie1,..., Ien) aktuelle Eingangsleistungswerte zu ermitteln, eine Differenz zwischen jeweils aktuell ermittelten Ausgangsleistungswerten und jeweils aktuell ermittelten Eingangsleistungswerten zu bestimmen, mit einer maximal zulässigen Leistungsdifferenz zu vergleichen und bei Überschreitung der maximal zulässigen Leistungsdifferenz den Stromfluss der zumindest einen Stromversorgung (SV, SV1, ..., SVn) zu unterbrechen.

10. Schaltung nach einen der Ansprüche 8 bis 9, ***dadurch gekennzeichnet, dass*** weiterhin eine Überwachungseinheit (UW) zum Empfangen eines Triggersignals (TS) der Auswerteeinheit (AW) und zum Senden eines Reset-Sginals (RS) bei Ausbleiben des Triggersignal (TS) vorgesehen ist.

11. Schaltung nach einem der Ansprüche 8 bis 10, ***dadurch gekennzeichnet, dass*** zum Unterbrechen des Stromflusses der zumindest einen Stromversorgung (SV) das Schaltelement (SE) der zumindest einen Stromversorgung (SV) durch der Auswerteeinheit (AW) entsprechend ansteuerbar ist.

12. Schaltung nach einem der Ansprüche 8 bis 10, ***dadurch gekennzeichnet, dass*** zum Unterbrechen des Stromflusses der zumindest einen Stromversorgung (SV1, ..., SVn) ein zusätzliches Schaltelement (SE1, ..., SEn) auf einer Eingangsseite der zumindest einen Stromversorgung (SV1, ..., SVn) angebracht ist oder ein der zumindest einen Stromversorgung (SV1, ..., SVn) Schaltwandler vorgelagert oder nachgelagert ist.

13. Schaltung nach einem der Ansprüche 8 bis 12, ***dadurch gekennzeichnet, dass*** als potentialgebundener Schaltwandler ein Schaltwandler nach dem so genannten SEPIC-Konzept (L1, SE, C1a, G1b, L2, D, C2) oder ein potentialgebundener Sperrwandler vorgesehen ist.

14. Schaltung nach Anspruch 13, ***dadurch gekennzeichnet, dass*** der Schaltwandler nach dem so genannten SEPIC-Konzept (L1, SE, C1a, C1b, L2, D, C2) serielle Längskondensatoren (C1a, C1b) aufweist.

15. Schaltung nach Anspruch 12, ***dadurch gekennzeichnet, dass*** als potentialgebundener Schaltwandler ein Tiefsetzsteller oder ein Hochsetzsteller vorgesehen ist.
